Europäisches Patentamt

European Patent Office

Office européen des brevets

(19)

(11) Veröffentlichungsnummer: **0 126 169**
**B1**

(12) **EUROPÄISCHE PATENTSCHRIFT**

(45) Veröffentlichungstag der Patentschrift:
**27.08.86**

(51) Int. Cl.⁴: **H 01 F 17/00, H 03 H 7/48**

(21) Anmeldenummer: **83104931.7**

(22) Anmeldetag: **19.05.83**

(54) Verteiler für Hochfrequenzenergie.

(43) Veröffentlichungstag der Anmeldung:
**28.11.84 Patentblatt 84/48**

(45) Bekanntmachung des Hinweises auf die Patenterteilung:
**27.08.86 Patentblatt 86/35**

(84) Benannte Vertragsstaaten:
**AT BE CH DE FR GB IT LI NL**

(56) Entgegenhaltungen:
**DE - A - 2 927 364**
**DE - A - 2 932 220**
**DE - A - 2 932 498**

(73) Patentinhaber: **ANT Nachrichtentechnik GmbH,
Gerberstrasse 33, D-7150 Backnang (DE)**

(72) Erfinder: **Macht, Gerhard, Dipl.-Ing.,
Nansenstrasse 21/6, D-7150 Backnang (DE)**

(74) Vertreter: **Schickle, Gerhard, Dipl.-Ing., ANT
Nachrichtentechnik GmbH Patent- und Lizenzabteilung
Gerberstrasse 33, D-7150 Backnang (DE)**

ACTORUM AG

**Beschreibung**

Die Erfindung betrifft eine Einrichtung zur gleichmässigen Aufteilung von Hochfrequenzenergie gemäss dem Oberbegriff des Patentanspruchs 1. Eine solche Einrichtung ist bekannt aus der DE-AS 1 807 938.

Die Einrichtung gemäss der DE-AS 1 807 938 besteht aus einem Sparübertrager, dessen Leiterbahnen E-förmig ausgebildet sind; und einem nachgeschalteten Differentialübertrager mit U-förmig ausgebildeten Leiterbahnen. Als Übertragerkerne werden zylindrische Einloch-Ferritkerne verwendet, die jeweils auf den Mittelschenkel der E-förmigen Leiterbahnen und auf einen Schenkel der U-förmigen Leiterbahnen aufgeschoben werden. Zum Aufschieben müssen die Schenkel von der Trägerplatte weggebogen werden und nach erfolgter Montage der Ferritkerne müssen die Schenkelenden mittels Verbindungsbrücken kontaktiert werden. Wegen der nicht genauen Reproduzierbarkeit der Lage dieser Verbindungsbrücken kann das Hochfrequenzverhalten des Verteilers ungünstig beeinflusst werden. Der Aufbau dieses Verteilers ist nicht in einer Ebene möglich, da insbesondere die Verbindungsbrücke zwischen den Aussenschenkeln der E-förmigen Leiterbahnen unter dem Mittelschenkel hindurchgeführt werden muss.

Aus der DE-AS 2 448 737 ist es bei einem Richtkoppler-Abzweiger bekannt, einen Zweiloch-Ferritkern mit Übertragerwicklungen zu versehen. Die Wicklungsenden können nach Verdrillen und Verzinnen in die auf einer Trägerplatte befindlichen Bohrungen gesteckt und verlötet werden. Die Realisierung eines solches Abzweigers ist aufwendig und teuer. Des weiteres haben die von Hand aufgebrachten Windungen gegenseitig auf den Kernen eine unterschiedliche Lage. Bei hohen Frequenzen führt dies zu Unterschieden im elektrischen Verhalten. Die Unterschiede müssen bei der Prüfung durch Zupfen an den Wicklungen ausgeglichen werden. Dies ist ebenfalls zeitaufwendig.

Der Erfindung liegt die Aufgabe zugrunde, eine Einrichtung zur gleichmässigen Aufteilung von Hochfrequenzenergie gemäss dem Oberbegriff des Patentanspruchs 1 so auszubilden, dass keine aufwendigen Montagearbeiten nötig sind und das Hochfrequenzverhalten der Einrichtung eindeutig festgelegt ist.

Erfindungsgemäss wird diese Aufgabe durch die kennzeichnenden Merkmale des Patentanspruchs 1 gelöst.

In den Unteransprüchen sind vorteilhafte Weiterbildungen der Erfindung angegeben.

Durch die Ausgestaltung des Verteilers sind die Wicklungen bzw. Leiterbahnen auf der Trägerplatte fixiert und führen bei der Massenfertigung zu genau reproduzierbaren Exemplaren mit gleichen elektrischen Messwerten. Die Herstellung des Verteilers ist kostengünstig, da kaum Montage- und Einbauarbeiten von Hand anfallen. Der Verteiler ist im Frequenzbereich von 5 bis 860 MHz ohne zusätzliche Schaltungs- und/oder Kompensationsmittel brauchbar.

Anhand der Zeichnungen wird die Erfindung nun näher erläutert. Es zeigen:

Fig. 1 ein elektrisches Schaltbild des Verteilers,

Fig. 2 den mechanischen Aufbau des Verteilers gemäss der Erfindung,

Fig. 3 eine Aufsicht auf den Verteiler mit aufgesetztem E-Kern und

Fig. 4 einen Schnitt durch die Trägerplatte mit eingebauten E-Kernen.

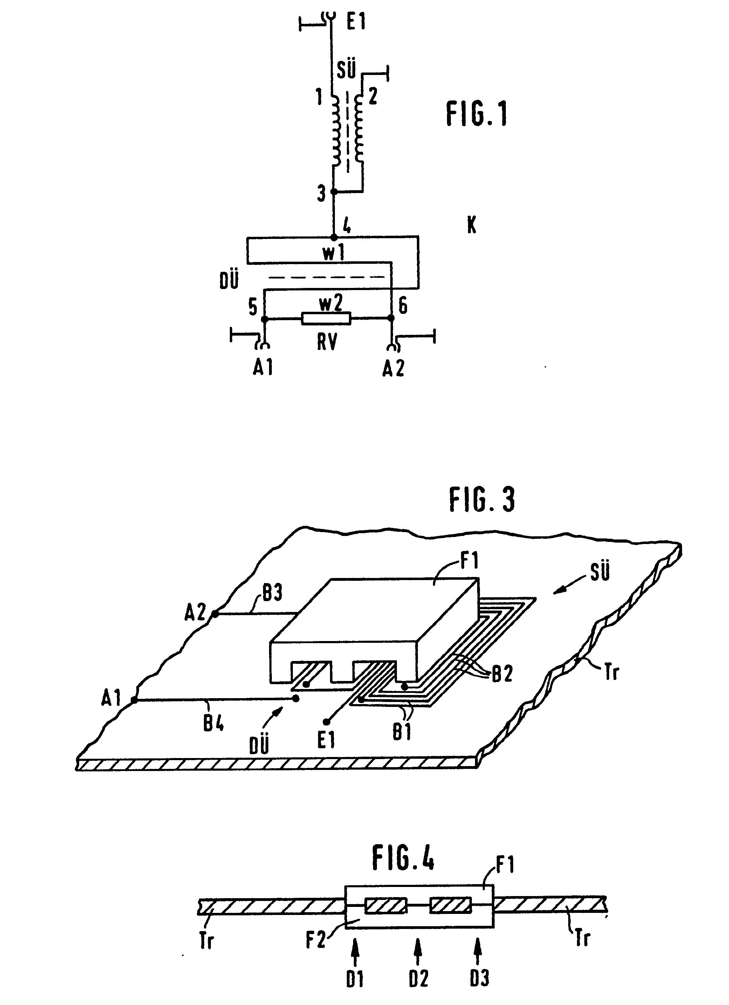

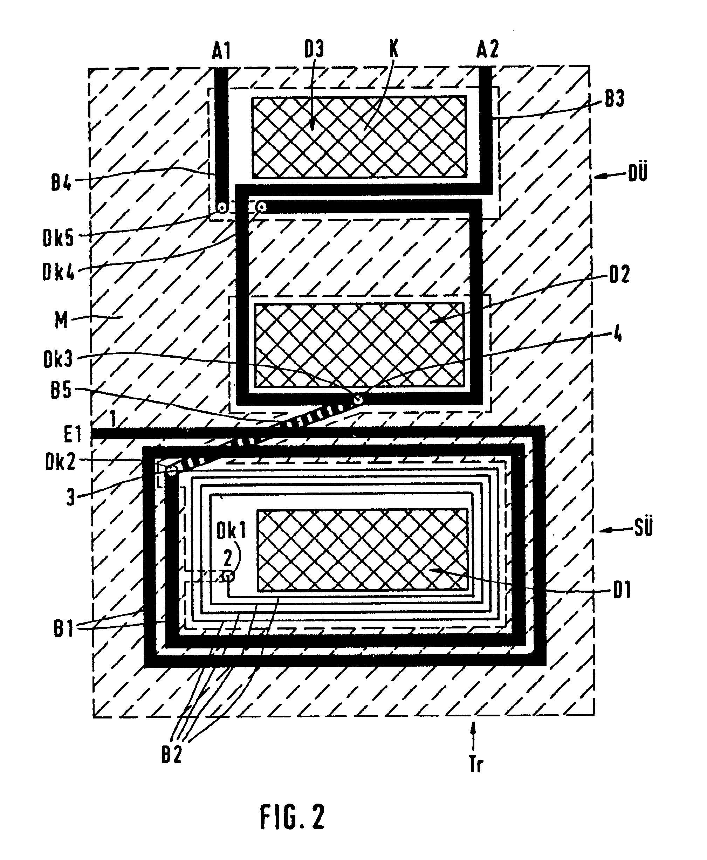

Im elektrischen Schaltbild des Verteilers nach Fig. 1 sind der Hochfrequenzsignaleingang mit E1 und die beiden Signalausgänge, auf die die Hochfrequenzenergie gleichmässig aufgeteilt wird, mit A1 und A2 bezeichnet. Der Wicklungsanfang 1 des Sparübertragers SÜ ist mit dem Hochfrequenzsignaleingang E1 und das Wicklungsende 2 mit Masse verbunden. Der Abgriffpunkt 3 des Sparübertragers SÜ ist mit dem gemeinsamen Verbindungspunkt 4 der zwei Wicklungen w1 und w2 des Differentialübertragers DÜ verbunden. Die Wicklungsanfänge 5 und 6 der Wicklungen w1 und w2 führen zu den Ausgängen A1 und A2. Wie in Fig. 2 ebenfalls dargestellt, bestehen die Wicklungen w1 und w2 jeweils aus Leiterbahnschleifen B3 und B4, die einen Ferritkern K gegensinnig umschliessen. Der Differentialübertrager DÜ ist durch einen ohmschen Verlustwiderstand RV überbrückt. Der Wert von RV beträgt ungefähr 2Z, wobei Z den Wellenwiderstand der angeschlossenen Leitungen darstellt. Das Übersetzungsverhältnis des Sparübertragers SÜ wurde 2:5 gewählt. Dies gilt unter der Voraussetzung, dass sowohl Eingang E1 wie die Ausgänge A1 und A2 mit Leitungen gleichen Wellenwiderstandes — beispielsweise 75 $\Omega$ — abgeschlossen werden. In Fig. 2 ist der mechanische Aufbau des Verteilers gemäss der Erfindung dargestellt. Dabei wurden die gleichen Bezugszeichen wie in Fig. 1 verwendet. Auf der einen Seite einer Trägerplatte Tr sind die Leiterbahnen B1 und B2 des Sparübertragers SÜ zentrisch zu dem Durchbruch D1 in der Trägerplatte Tr angeordnet. Die Leiterbahn B1 zwischen den Punkten 1 und 3 liegt aussen. Auf der Rückseite der Trägerplatte Tr ist unter ihr ein Massebelag M — gestrichelt dargestellt — aufgebracht. B1 besitzt daher das Verhalten einer Strip-Line. Die sich an B1 mit dem gleichen Wickelsinn nach innen anschliessende Wicklung B2 des Sparübertragers SÜ — dünn gezeichnet — besitzt auf der Unterseite der Trägerplatte Tr keinen Massebelag M. Das Wicklungsende 2 des Sparübertragers SÜ ist über eine Druckkontaktierung Dk1 mit dem Massebelag M auf der Rückseite der Trägerplatte Tr verbunden. Der Abgriff 3 des Sparübertragers SÜ ist über eine Durchkontaktierung Dk2 mit einem Ende einer Leiterbahn B5 — in Fig. 2 gestrichelt — verbunden. Diese auf der Rückseite der Trägerplatte Tr aufgebrachte Leiterbahn 5 ist vom Massebelag M durch Schlitze getrennt. Die Leiterbahn B5 führt schräg unter den Leiterbahnzügen von B1 hindurch. Das andere Ende von B5 ist über die Durchkontaktierung Dk3 mit dem gemeinsamen Verbindungspunkt 4 der Leiterbahnschleifen B3 und B4 — in Fig. 1 dargestellt durch die Wicklungen w1 und w2 — auf der Oberseite der Trägerplatte verbunden. Die Leiterbahnen B3 und B4 laufen ausgehend vom Verbindungspunkt 4 längs einer Breitseite des Durchbruchs D2, und zwar B3 nach links und B4 nach rechts. Von den Enden dieser Breitseite aus verlaufen sie jeweils entlang einer Schmalseite des Durchbruchs D2 und behalten diese Richtung auch nach Verlassen der Schmalseiten von D2 bei bis in die Nähe des Durchbruchs D3, wo sie ihre Richtung ändern. Die Leiterbahnen B3 und B4 umschlingen gegensinnig den Durchbruch D3 bis zu den Ausgängen A1 und A2. B3 läuft an der Breitseite des Durchbruchs D3 innen entlang von links nach rechts und B4 aussen von rechts nach links parallel zu B3. An der Überkreuzungsstelle von B3 und B4 ist der Leiterbahnzug von B4 auf die Rückseite der Trägerplatte Tr verlegt. Dazu sind für B4 die Durchkontaktierungen Dk4 und Dk5 vorgesehen. Von den Enden der Breitseite des Durchbruchs D3 bis zu den Ausgängen A1 und A2 laufen die Leiterbahnen B3 und B4 jeweils entlang einer Schmalseite von D3. Der Massebelag M auf der Rückseite weist in der Umgebung der Durchbrüche D2 und D3 Aussparungen auf, so dass die Leiterbahnen B3 und B4 beim Umschlingen der Durchbrüche rückseitig keinen Massebelag aufweisen.

In Fig. 3 ist in einer Aufsicht die Trägerplatte Tr dargestellt. In die drei Durchbrüche ist von oben ein E-Kern F1 aufgesetzt. Wie Fig. 4 im Schnitt zeigt, wird auch von unten ein E-Kern F2 in die Durchbrüche D1, D2, D3 eingesetzt. Beide E-förmigen Ferritkernhälften F1 und F2 bilden um die Wicklungen bzw. Leiterbahnen, des Sparübertragers SÜ und des Differentialübertragers DÜ in sich geschlossene magnetische Kreise. Anstelle zweier E-förmiger Ferritkernhälften können auch vier U-förmige Kernteile verwendet werden. Eine E-förmige Ferritkernhälfte setzt sich dann aus zwei nebeneinandergestellten U-Kernteilen zusammen.

Wählt man für die Ferritkernhälften bzw. Kernteile des Sparübertragers SÜ niederpermeables verlustarmes Ferritmaterial und für jene des Differentialübertragers DÜ hochpermeables verlustreiches Ferritmaterial, so kann der Verlustwiderstand RV im Schaltbild nach Fig. 1 eingespart werden, da der magnetische Kreis von DÜ ausreichend verluftbehaftet ist.

Die Leiterbahnen können jeweils zur einen Hälfte auf einer Seite der Trägerplatte Tr angeordnet sein und sich mit ihrer anderen Hälfte mit gleichem Wicklungssinn auf der anderen Seite von Tr fortsetzen. Somit ist es möglich, Platz einzusparen, indem man die Leiterbahnhälften bezüglich der Trägerplatte Tr untereinander anordnet. Eine Realisierung als Strip-Line ist bei untereinander angeordneten Leiterbahnzügen nicht möglich.

Der Differentialübertrager DÜ kann natürlich auch Mehrfachwicklungen aufweisen, so dass eine Aufteilung der Hochfrequenzenergie auf mehr als zwei Ausgänge möglich ist.

**Patentansprüche**

1. Einrichtung zur gleichmässigen Aufteilung von Hochfrequenzenergie auf zwei oder mehr Verbraucher unter Verwendung eines eine Impedanztransformation bewirkenden Sparübertragers (SÜ) und eines diesem Sparübertrager nachgeschalteten Differentialübertragers (DÜ), deren Wicklungen in Form streifenförmiger Leiterbahnen ausgebildet und zum grössten Teil auf einer beidseitig beschichteten Trägerplatte (Tr) angeordnet sind, wobei der Differentialübertrager (DÜ) mit einem verlustbehafteten Bauelement beschaltet ist, dadurch gekennzeichnet, dass die Leiterbahnen (B1, B2) des Sparübertragers (SÜ) zentrisch zu einem ersten Durchbruch (D1) in der Trägerplatte (Tr) angeordnet sind, dass die mit dem Sparübertrager (SÜ) verbundenen Leiterbahnschleifen (B3, B4) des Differentialübertragers (DÜ) einen zweiten Durchbruch (D2) in der Trägerplatte (Tr) zumindest teilweise umschliessen, dass die zu den Ausgängen (A1, A2) führenden Leiterbahnschleifen (B3, B4) des Differentialübertragers (DÜ) einen dritten Durchbruch (D3) in der Trägerplatte (Tr) gegensinnig zumindest teilweise umschliessen und dass in die Durchbrüche (D1, D2, D3) Ferritkernhälften (F1, F2) derart eingebracht sind, dass sich um die Wicklungen von Sparübertrager (SÜ) und Differentialübertrager (DÜ) jeweils in sich geschlossene magnetische Kreise bilden.

2. Einrichtung nach Anspruch 1, dadurch gekennzeichnet, dass die Ferritkernhälften (F1, F2) jeweils E-förmig ausgebildet sind und dass deren Schenkel jeweils von oben und unten in die Durchbrüche (D1, D2, D3) einbringbar sind.

3. Einrichtung nach Anspruch 1, dadurch gekennzeichnet, dass die Ferritkernhälften (F1, F2) aus jeweils zwei U-förmigen Kernteilen gebildet sind, deren Schenkel jeweils von oben und unten in die Durchbrüche (D1, D2, D3) einbringbar sind.

4. Einrichtung nach Anspruch 1 oder 3, dadurch gekennzeichnet, dass die Ferritkernhälften (F1, F2) bzw. Kernteile, für den Sparübertrager (SÜ) aus niederpermeablem, verlustarmem Material und jene für den Differentialübertrager (DÜ) aus hochpermeablem, verlustreichem Material bestehen.

5. Einrichtung nach Anspruch 1, dadurch gekennzeichnet, dass die eine Hälfte der zentrisch zu einem Durchbruch (D1, D2, D3) angeordneten Leiterbahnen auf einer Seite der Trägerplatte (Tr) angeordnet ist, und sich die andere Hälfte auf der anderen Seite der Trägerplatte (Tr) mit gleichem Wickelsinn fortsetzt.

6. Einrichtung nach Anspruch 1, dadurch gekennzeichnet, dass die den Leiterbahnen abgewandte Seite der Trägerplatte (Tr) als Massebelag ausgebildet ist, und dass dieser Massebelag Aussparungen in der Umgebung der Durchbrüche (D1, D2, D3) und einem Teil der Leiterbahnen (B2, B3, B4) aufweist.

7. Einrichtung nach einem der Ansprüche 1, 5 und 6, dadurch gekennzeichnet, dass zumindest eine Leiterbahn (B1) als Strip-Line ausgebildet ist.

**Claims**

1. Equipment for the uniform distribution of highfrequency energy over two or more loads with the use of an autotransformer (SÜ) effecting an impedance transformation and a differential transformer (DÜ) connected behind this autotransformer, the windings of which transformers are constructed in the form of strip-shaped conductor tracks and arranged for the largest part on a carrier plate (Tr) coated on both sides, wherein the differential transformer (DÜ) is wired to a dissipative component, characterised thereby, that the conductor tracks (B1, B2) of the autotransformer (SÜ) are arranged centred with respect to a first opneing (D1) in the carrier plate (Tr), that the conductor track loops (B3, B4) of the differential transformer (DÜ), which are connected with the autotransformer (SÜ), at least partially enclose a second opening (D2) in the carrier plate (Tr), that the conductor track loops (B3, B4) of the differential transformer (DÜ), which lead to the outputs (A1, A2), at least partially and in opposite sense enclose a third opening (D3) in the carrier plate (Tr) and that ferrite core halves (F1, F2) are placed into the openings (D1, D2, D3) in such a manner that respective closed magnetic circuits are formed around the windings of autotransformer (SÜ) and differential transformer (DÜ).

2. Equipment according to claim 1, characterised thereby, that the ferrite core halves (F1, F2) are each constructed in E-shape and that their limbs are respectively introduceable from above and below into the openings (D1, D2, D3). '

3. Equipment according to claim 1, characterised thereby, that the ferrite core halves (F1, F2) are each formed of two respective U-shaped core parts, the limbs of which are respectively introduceable from above and below into the openings (D1, D2, D3).

4. Equipment according to claim 1 or 3, characterised thereby, that the ferrite core halves (F1, F2) or core parts for the autotransformer (SÜ) consist of low permeability, low loss material and those for the differential transformer (DÜ) of high permeability, high loss material.

5. Equipment according to claim 1, characterised thereby, that one half of the conductor tracks, which are arranged centred with respect to an opening (D1, D2, D3), is arranged on one side of the carrier plate (Tr) and the other half continues in the same winding sense on the other side of the carrier plate (Tr).

6. Equipment according to claim 1, characterised thereby, that side of the carrier plate (Tr), which is remote from the conductor tracks, is contructed as earth layer and that this earth layer displays cut-outs in the region of the openings (D1, D2, D3) and a part of the conductor tracks (B2, B3, B4).

7. Equipment according to one of the claims 1, 5 and 6, characterised thereby, that at least one conductor track (B1) is constructed as strip-line.

## Revendications

1.Dispositif pour uniformément répartir de l'énergie à haute fréquence sur deux ou davantage de consommateurs, avec utilisation d'un autotransformateur (SÜ), produisant une transformation d'impédance, et d'un transformateur différentiel (DÜ) prévu à la suite de l'autotransformateur et dont les enroulements sont réalisés comme des pistes conductives en forme de rubans et sont disposés en majeure partie sur une plaque support (Tr) revtue des côtés, un composant produisant des pertes étant monté sur le transformateur différentiel (DÜ), caractérisé en ce que les pistes conductives (B1, B2) de l'autotransformateur (SÜ) sont disposées de façon centrée par rapport à une première découpe (D1) de la plaque support (Tr), que les boucles de pistes conductives (B3, B4) du transformateur différentiel (DÜ), reliées à l'autotransformateur (SÜ), entourent en partie au moins une deuxième découpe (D2) de la plaque support (Tr), que les boucles de piste conductives (B3, B4) du transformateur différentiel (DÜ) menant aux sorties (A1, A2) entourent en partie au moins et en sens contraire une troisième découpe (D3) de la plaque support (Tr) et que des demi-noyaux de ferrite (F1, F2) sont disposés de telle manière dans les découpes (D1, D2, D3) que des circuits magnétiques fermées en eux-mêmes sont formés autour des enroulements de l'autotransformateur (SÜ) et du transformateur différentiel (DÜ).

2. Dispositif selon la revendication 1, caractérisé en ce que les demi-noyaux de ferrite (F1, F2) sont chacun en forme de E et que leurs branches peuvent être introduites d'en haut et d'en bas dans les découpes (D1, D2, D3).

3. Dispositif selon la revendication 1, caractérisé en ce que les demi-noyaux de ferrite (F1, F2) sont formés chaque fois de deux pièces de noyau en U dont les branches peuvent être introduites d'en haut et d'en bas dans les découpes (D1, D2, D3).

4. Dispositif selon la revendication 1 ou 3, caractérisé en ce que les demi-noyaux de ferrite (F1, F2) ou les pièces de noyau pour l'autotransformateur (SÜ) sont en matériau à faible perméabilité et à faibles pertes et que ceux du transformateur différentiel (DÜ) sont en matériau à haute perméabilité et à grosses pertes.

5. Dispositif selon la revendication 1, caractérisé en ce que l'une des moitiés des pistes conductives agencées de façon centrée par rapport à une découpe (D1, D2, D3) est disposée sur un côté de la plaque support (Tr) et que l'autre moitié continue avec le même sens de bobinage sur l'autre côté de la plaque support (Tr).

6. Dispositif selon la revendication 1, caractérisé en ce que le côté de la plaque support (Tr) opposé à celui portant les pistes conductives est réalisé sous forme d'un revêtement relié à la masse et que ce revêtement présente des évidements dans la région des découpes (D1, D2, D3) et d'une partie des pistes conductives (B2, B3, B4).

7. Dispositif selon une des revendications 1, 5 et 6, caractérisé en ce qu'au moins une piste conductive (B1) est réalisée comme guide d'ondes à ruban.

E1

SÜ

1    2

3

4    K

w1

DÜ

5    w2    6

RV

A1    A2

**FIG.1**

**FIG. 3**

F1

B3

SÜ

A2

B2    Tr

A1

B4    E1    B1

DÜ

**FIG.4**    F1

Tr    F2    Tr

D1    D2    D3

FIG. 2